# EUROPÄISCHE PATENTSCHRIFT

(11) **EP 1 604 438 B1**
(45) Veröffentlichungstag und Bekanntmachung des Hinweises auf die Patenterteilung: **11.10.2006**
(21) Anmeldenummer: 04716576.6
(22) Anmeldetag: 03.03.2004
(51) Int. Cl.: H02B 1/56, H05K 7/20

(54) **KÜHLMITTELFÜHRUNGSELEMENT UND KÜHLMITTELFÜHRUNGSEINRICHTUNG**
COOLANT GUIDING ELEMENT AND COOLANT GUIDING DEVICE
ELEMENT DE CONDUITE DE FLUIDE DE REFROIDISSEMENT ET DISPOSITIF DE CONDUITE DE FLUIDE DE REFROIDISSEMENT

(30) Priorität: 11.03.2003 DE 10311380
(43) Veröffentlichungstag der Anmeldung: 14.12.2005
(73) Patentinhaber: Rittal GmbH & Co. KG, 35745 Herborn (DE)
(72) Erfinder: HARTEL, Marc, 35447 Reiskirchen (DE); DAHMER, Ralf, 57462 Olpe (DE)
(74) Vertreter: Fleck, Hermann-Joseph
(86) Internationale Anmeldenummer: PCT/EP2004/002101
(87) Internationale Veröffentlichungsnummer: WO 2004/082088

(56) Entgegenhaltungen:
- DE-U- 20 203 883
- FR-A- 2 359 579
- PATENT ABSTRACTS OF JAPAN vol. 2003, no. 04, 2. April 2003 (2003-04-02) -& JP 2002 374086 A (HITACHI LTD;HITACHI INFORMATION TECHNOLOGY CO LTD), 26. Dezember 2002 (2002-12-26)
- PATENT ABSTRACTS OF JAPAN vol. 014, no. 396 (E-0970), 27. August 1990 (1990-08-27) -& JP 02 148891 A (NEC CORP), 7. Juni 1990 (1990-06-07)

## Beschreibung

Die Erfindung bezieht sich auf ein Schaltschrank-Rahmengestell, Rack oder IT-Arbeitsplatzsystem mit einer Kühlmittel-Führungseinrichtung, die mindestens ein Kühlmittelführungselement mit einem umschlossenen längserstreckten hohlen Profilkörper aufweist, dessen Außenwandung mit einer Vielzahl von in Längsrichtung voneinander beabstandeten, freiliegenden oder abgeschlossenen und freigebbaren Zugangsöffnungen zu einer im Inneren befindlichen Kanalanordnung versehen ist.

Ein derartiges Rahmengestell eines Schaltschranks, Racks oder IT-Arbeitsplatzsystems mit einem Rahmenprofil, in welchem eine Kühlmittelführung aufgenommen ist, ist in der DE 202 03 883 U1 angegeben. Die Kühlmittelführung ist entlang einer Längsseite des Rahmenprofils zugänglich. Bei diesem Aufbau ist das Rahmengestell vorteilhaft für die Kühlmittelführung genutzt, jedoch ergeben sich Anwendungsfälle, in denen eine verbesserte Kühlwirkung wünschenswert ist.

Der Erfindung liegt die Aufgabe zugrunde, ein Schaltschrank-Rahmengestell, Rack oder IT-Arbeitsplatzsystem der eingangs genannten Art bereitzustellen, bei dem mit einfachen Montagemöglichkeiten eine verbesserte Kühlwirkung erreicht werden kann.

Diese Aufgabe wird mit den Merkmalen des Anspruches 1 gelöst. Dabei ist bei dem Kühlmittelführungselement vorgesehen, dass die Kanalanordnung einen Vorlaufkanal und einen Rücklaufkanal aufweist, denen jeweils eine Reihe von Zugangsöffnungen zugeordnet ist. Mit diesen Maßnahmen wird der Aufbau eines Kühlsystems mit einer gezielten Kühlmittelzufuhr und -abfuhr erwärmten Kühlmittels bei einfachen Installationsmaßnahmen ermöglicht.

Bei kompaktem Aufbau wird mit einfachen Maßnahmen die Wirksamkeit der Kühlung dadurch begünstigt, dass der Vorlaufkanal und der Rücklaufkanal mittels einer einstückigen Trennwand des Profilkörpers voneinander getrennt sind.

Hierbei ist vorteilhaft vorgesehen, dass die Trennwand mit einem Isoliermittel geringerer Wärmeleitfähigkeit als das Material des Profilkörpers versehen ist.

Vorteilhafte Ausgestaltungsvarianten bestehen dabei darin, dass das Isoliermittel ein sich über die Länge und im Wesentlichen die Breite der Trennwand erstreckender Hohlraum oder ein wärmeisolierender Festkörper ist.

Für die Kühlmittelführung und Kühlleistüng sind weiterhin die Maßnahmen vorteilhaft, dass die umgebenden Wandflächen des Vorlaufkanals und des Rücklaufkanals beschichtet sind.

Für die Herstellung und den Einsatz vorteilhafte Ausgestaltungen ergeben sich ferner dadurch, dass der Profilkörper aus Metall oder Kunststoff extrudiert ist.

Der Aufbau der Kühlmittelführungseinrichtung wird dadurch begünstigt, dass das Kühlmittelführungselement entlang einem Rahmenschenkel an mindestens einer Montageschiene oder an der Innenseite eines Verkleidungsteils angebracht ist.

Die Installation und z.B. auch Nachrüstung oder Abänderung der Kühlmittelführungseinrichtung werden dadurch begünstigt, dass der Rahmenschenkel als Rahmenprofil mit einer integrierten, zum Innenraum des Schaltschrankes oder Racks offenen Kammer ausgebildet ist, in die das Kühlmittelführungselement eingesetzt ist.

Zu einer einfachen Montage tragen die Maßnahmen bei, dass in der Kammer Haltemittel ausgebildet sind, mit denen das Kühlmittelführungselement in dieser fixiert ist.

Verschiedene weitere Ausgestaltungsmöglichkeiten bestehen darin, dass das Kühlmittelführungselement in der Kammer eingerastet, in diesem festgeschraubt, eingeklebt, eingeschweißt oder eingelötet oder eingeklemmt ist.

Verschiedene Installationsmöglichkeiten ergeben sich dadurch, dass das Kühlmittelführungselement von einer stirnseitigen Öffnung aus in Längsrichtung des Trageprofils eingeschoben ist oder senkrecht zur Längsrichtung über eine Längsöffnung des Trageprofils einsetzbar ist und dass das Kühlmittelführungselement auf seiner zugänglichen Längsseite mit den Zugangsöffnungen versehen ist.

Eine verbesserte Kühlwirkung kann dadurch erzielt werden, dass entlang dem Kühlmittelführungselement in Längsrichtung verlaufende Kühlrippen angeordnet sind.

Ein Montageraum wird dadurch bei möglichst hohem Wirkungsgrad günstig nutzbar, dass die äußere Querschnittskontur des Kühlmittelführungselementes an die innere Querschnittskontur der Kammer angepasst ist.

Für den Aufbau und z.B. die Stabilität sowie die Montagemöglichkeiten eines Rahmengestelles ergeben sich weitere Vorteile dadurch, dass das Rahmenprofil mindestens zwei Kammern aufweist, von denen eine die Aufnahme-Kammer für das Kühlmittelführungselement bildet und die weitere(n) zu Montagezwecken und/oder Verstärkungszwecken dient (dienen).

Ein einfaches Festlegen der Kühlmittelführungselemente ergibt sich bei einfachem Aufbau dadurch, dass im lichten Öffnungsbereich der Kammer zwei gegeneinander gerichtete Haltestege angeordnet sind.

Ist vorgesehen, dass das Kühlmittelführungselement über ein oder zwei auf einer oder beiden Stirnseiten in das Rahmenprofil eingesetzte(s) Anschlussteil(e) und/oder über in die Zugangsöffnungen eingesetzte Adapter an eine Kühlmittelzuführung und/oder -abführung angeschlossen oder anschließbar ist, werden einfache Anschlussmöglichkeiten an Kühlaggregate erreicht.

Ein vorteilhafter Aufbau der Kühlmittelführungseinrichtung besteht darin, dass das Kühlmittelführungselement ein flüssiges Kühlmedium führt und an einen Luft/Flüssigkeits-Wärmetauscher und/oder einen Flüssigkeits/Flüssigkeits-Wärmetauscher angeschlossen ist.

Eine gezielte und wirksame Kühlung insbesondere stark wärmeproduzierender elektronischer Bauelemente wird dadurch erreicht, dass das Kühlmittelführungselement über die Zugangsöffnungen an mit Elektronikbaugruppen thermisch gekoppelte Kühlelemente angeschlossen ist.

Die Erfindung wird nachfolgend anhand von Ausführungsbeispielen unter Bezugnahme auf die Zeichnungen näher erläutert. Es zeigen:
- Fig. 1A, 1B und 1C: jeweils einen Abschnitt eines Rahmenprofils mit einem eingesetzten oder einsetzbaren Kühlmittelführungselement in perspektivischer Ansicht,
- Fig. 2: einen Ausschnitt eines Rahmengestelles im Bereich einer Ecke, wobei ein vertikaler Rahmenschenkel als Rahmenprofil mit einer Kühlmittelführung ausgebildet ist,
- Fig. 3: eine perspektivische Darstellung eines Rahmenprofils und eines einzusetzenden Kühlmittelführungselementes und
- Fig. 4: eine schematische Darstellung einer Kühlmittelführungseinrichtung mit einem Kühlmittelführungselement nach den Fig. 1A bis 3.

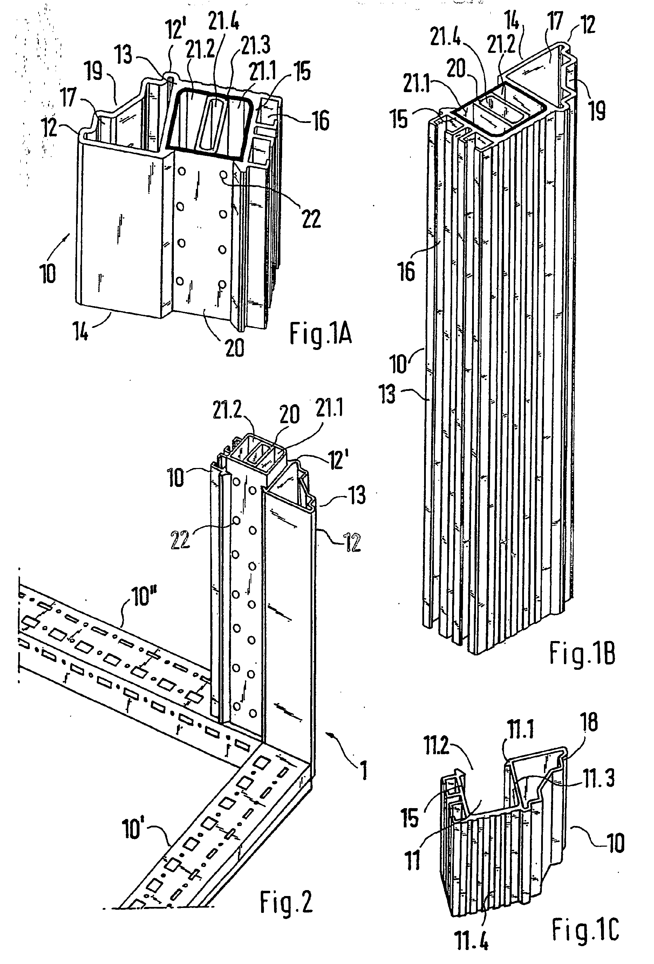

Ein in den Fig. 1A bis 3 gezeigter Rahmenschenkel in Form eines Rahmenprofils 10 ist als Mehrkammerprofil ausgebildet, wobei zum Aufbau eines Rahmengestelles 1 (vgl. Fig. 2) nach außen gerichtete Dichtränder 12, 12' sowie in einem Außenkantenbereich ein Freiraum 19 mit einer schräg verlaufenden Profilwand gebildet sind, während zum Innenraum des aufzubauenden Rahmengestelles 1 ein offener Hohlraum in Form einer Kammer 11 vorgesehen ist. In die Kammer 11 ist ein Kühlmittelführungselement 20 in Form eines geschlossenen Mehrkammer-Hohlprofils eingesetzt. Das Innere des Hohlprofils weist eine Kanalanordnung mit Führungskanälen 21, nämlich einem Vorlaufkanal 21.1 und einem davon mittels einer Trennwand 21.3 getrennten Rücklaufkanal 21.2 auf. Auf der zum Innenraum gerichteten Öffnungsseite des Kühlmittelführungselementes 20 sind eine Reihe von Zugangsöffnungen 22 angeordnet, über die eine Strömungsverbindung zu den im Inneren des Kühlmittelführungselementes 20 verlaufenden Führungskanälen 21 hergestellt wird. Die Zugangsöffnungen 22 können mittels vorgesehener Sollbruchstellen oder eingesetzter Deckel verschlossen oder mit Anschlusselementen belegt sein oder zum Kühlen des Schrankinneren auch offen bleiben.

Das Kühlmittelführungselement 20 ist in seinem Außenquerschnitt an den Innenquerschnitt des Hohlraumes 11 angepasst und besteht aus einem für das jeweilige zu führende Kühlmittel, z.B. Luft oder eine Kühlflüssigkeit, aus geeignetem Material, insbesondere Kunststoff oder Metall. Die Trennwand 21.3 ist einstückig in dem Kühlmittelführungselement 20 z.B. während eines Extrudiervorganges eingebracht. Die Trennwand 21.3 ist wärmeisolierend ausgebildet, wozu in diese als Isoliermittel 21.4 eine weitere Hohlkammer oder auch ein gut wärmeisolierendes Festkörperelement eingebracht ist. Die den Vorlaufkanal 21.1 und den Rücklaufkanal 21.2 umgebenden Wandflächen können mit glattem und/oder wärmeisolierendem und beständigem Material beschichtet sein.

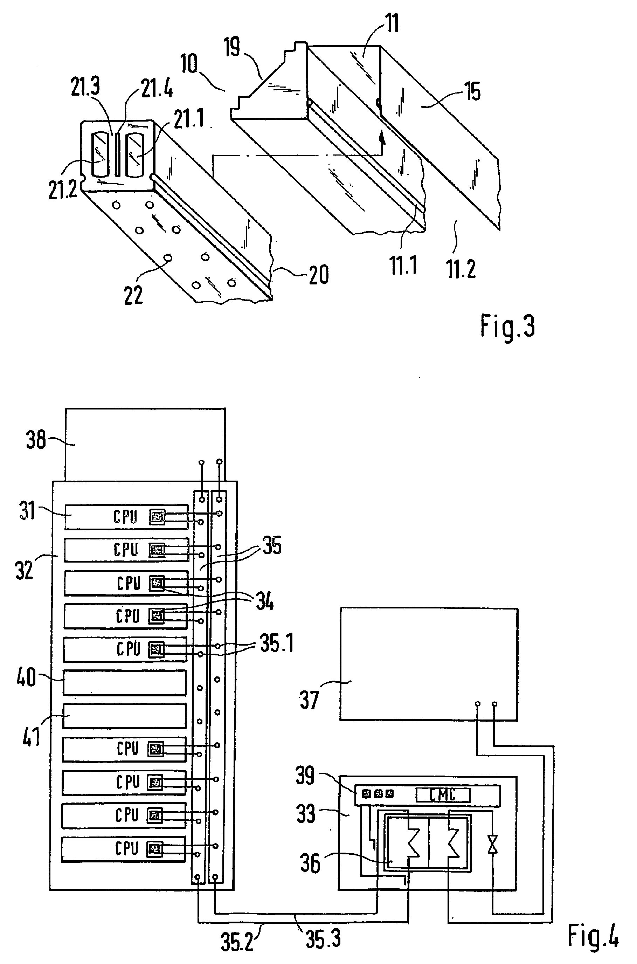

Das das Kühlmittelführungselement 20 aufnehmende Rahmenprofil 10 bildet ein Trageprofil mit einem Trageprofilabschnitt 13 für das Rahmengestell 1. Der von der inneren Öffnungsseite in Form der Längsöffnung 11.2 aus zugängliche Hohlraum 11 besitzt eine etwa rechteckförmige oder quadratische Grundform, die von seitlichen Wänden 11.3 und einer Basiswand 11.4 umgeben ist und an den freien Bereichen der seitlichen Wände 11.3 im Bereich der Längsöffnung 11.2 mit gegeneinander gerichteten Haltestegen 11.1 oder Halterippen (vgl. Fig. 3) versehen ist, die nach außen hin mit Einführschrägen oder Rundungen und zum Inneren des Hohlraums bzw. der Kammer 11 hin z.B. mit rechtwinkligen Absätzen versehen sind, so dass die Kühlmittelführung 20, die auf ihrer von den Zugangsöffnungen 22 abgelegenen Seite gerundete Kanten besitzt, rastend eingedrückt werden kann, wenn das Rahmenprofil 10 und/oder das Kühlmittelführungselement 20 entsprechend elastisch ausgebildet ist/sind. Alternativ ist auch denkbar, das Kühlmittelführungselement 20 in Längsrichtung in den Hohlraum 11 einzuführen.

Das Rahmenprofil 10 wird vorteilhaft als zumindest ein vertikaler Rahmenschenkel des Rahmengestelles 1 verwendet, der mit geeigneten Eckverbindern oder durch einfache Verschraubung mit einem aus horizontalen Rahmenschenkeln 10, 10', 10" in der Breite bzw. Tiefe gebildeten Deckrahmen und Bodenrahmen verbunden ist, wie die Fig. 2 zeigt. Bei dem Rahmengestell 1 kann das Kühlmittel stirnseitig oder durch geeignete Zugangsöffnungen 22 in das Kühlmittelführungselement 20 eingeleitet und aus diesem auch wieder z.B. mit einer Pumpe oder einem Gebläse abgeführt werden. An weitere Zugangsöffnungen 22 können zu kühlende Einbaugeräte mit entsprechenden Leitungen und Anschlüssen an ihrem Gehäuse individuell angeschlossen oder aber der gesamte Schaltschrank-Innenraum gekühlt werden. Dabei kann über den Vorlaufkanal 21.1 Kühlflüssigkeit oder Kühlluft zugeführt und über den Rücklaufkanal 21.2 erwärmte Kühlflüssigkeit bzw. Luft abgeführt werden.

Das Kühlmittelführungselement 20 kann auch in Längsrichtung angeordnete Kühlrippen 23 aufweisen, die z.B. auf einer den Führungskanälen 21 abschließenden, parallel zur Öffnungsseite verlaufenden Zwischenwand zur Öffnungsseite vorstehen. Die Kühlrippen können auf diese Weise über die Zugangsöffnungen 22 zugeführte erwärmte Luft kühlen, wobei die Wärme über das in den Führungskanälen 21 strömende Kühlmittel, Flüssigkeit oder Luft, abgeführt werden kann.

Das Rahmenprofil 10 weist z.B., wie Fig. 1C zeigt, eine eine seitliche Wandung 11.3 bildende äußere Profilseite 15 sowie eine zum Inneren des Rahmengestelles 1 gewandte innere Profilseite 14 auf, wie auch aus den Fig. 1 A, 1 B und 3 in Verbindung mit Fig. 2 hervorgeht. Vorliegend sind auf der äußeren Profilseite 15 zwei in Längsrichtung verlaufende T-Nuten 16 ausgebildet, über die Befestigungsmöglichkeiten für Montageelemente bestehen. Weiterhin können in der inneren Profilseite 14, die sich seitlich der Längsöffnung 11.2 in Richtung zur Außenseite des Rahmengestelles 1 anschließt und die innere Wandung einer weiteren, geschlossenen Kammer 17 des Rahmenprofils 10 bildet, z.B. Reihen von Befestigungsdurchbrüchen vorgesehen sein, mit denen weitere Montagemöglichkeiten bestehen, wie z.B. die in Fig. 2 dargestellten unteren horizontalen Rahmenschenkel zeigen und an sich bekannt.

Bei einem Arbeitsplatzsystem, etwa mit einer Tischanordnung, können z.B. die seitlichen Träger als säulenartige Rahmenschenkel aus Rahmenprofilen 10 mit Kühlmittelführung entsprechend den vorstehenden Ausführungen ausgebildet sein. Die Zugangsöffnungen zu den Kühlmittelführungen sind auf der der Tischplatte bzw. einem darüber angeordneten Ablageboden zugekehrten Innenseite oder Außenseite der Rahmenschenkel angeordnet, so dass auf der Tischplatte oder den Ablagebögen positionierte elektrische Geräte, insbesondere informationstechnische Geräte, wie Computer, Server oder Monitore oder dgl. zur Kühlung leicht an die Kühlmittelführung mit entsprechenden Adapterstücken angeschlossen werden können. Auf den Innenseiten der vertikalen Rahmenschenkel sind eine oder mehrere in Längsrichtung verlaufende Reihen von Befestigungsaufnahmen zum Einhängen von Tragelementen für die Tischplatten bzw. Ablageböden oder ähnlichen Aufnahmeelementen eingebracht, in denen die Tragarme in Form.horizontaler Rahmenschenkel aus Rahmenprofilen mit Kühlmittelführungselementen der beschriebenen Art einhängbar oder anschraubbar sind. Die Ankopplung horizontaler und vertikaler Kühlmittelführungselemente 20 kann mittels einfacher Koppelstücke erfolgen, die einen Kanal für das Kühlmittel und Koppelelemente aufweisen. Die Rahmenschenkel sind zumindest auf ihrer Innenseite vorzugsweise flach ausgebildet und können z.B. im Wesentlichen rechteckförmigen Querschnitt besitzen oder auf ihrer Außenseite abgerundet sein. Mit den Rahmenprofilen als vertikale und/oder horizontale Rahmenschenkel ergeben sich vielfältige Anschlussmöglichkeiten und Verzweigungsmöglichkeiten der Kühlmittelzuführung.

Unter den genannten Begriffen Rahmengestell, Rack, Schaltschrank, Arbeitsplatzsystem sind insbesondere auch derartige Anordnungen oder Kombinationen daraus für die Informationstechnik (IT) zu verstehen, also z.B. auch Gestellaufbauten oder Regale oder Tische für Monitore oder Serverschränke oder dgl.

Fig. 4 zeigt ein Aufbaubeispiel für eine Kühlmittelführungseinrichtung mit einem in der vorstehend beschriebenen Weise eingesetzten Kühlmittelführungselement 20. Die Kühlmittelführungseinrichtung ist dabei als Flüssigkeits-Kühlsystem zum Kühlen einer Vielzahl von in einem Rack 32 aufgenommenen Elektronikbaugruppen 31 ausgeführt, die jeweils als Haupt-Wärmeproduzenten mindestens eine zentrale Prozessoreinheit (CPU) 1.1 hoher Rechnerleistung in einem die Elektronikbaugruppe 31 beinhaltenden Gehäuse aufweisen.

Zum Kühlen der Elektronikbaugruppe 31, insbesondere der Prozessoreinheiten bzw. Rechnereinheiten, die als ein integriertes Bauelement ausgebildet sind, sind auf dem Bauelementkörper mit Kanälen versehene Kühlelemente 34 der Flüssigkeits-Kühleinheiten in engem wärmeleitendem Kontakt aufgebracht, durch die die Kühlflüssigkeit über einen möglichst langen Weg geleitet wird. Die Flüssigkeits-Kühleinheiten mit den Kühlelementen 4 sind über jeweilige Vorlauf-Zweigleitungen und Rücklauf-Zweigleitungen mittels Koppelelementen über die Zugangsöffnungen 22 an den Vorlaufkanal 21.1 und den Rücklaufkanal 21.2 angeschlossen. In dem unteren Bereich ist das Kühlmittelführungselement 20 über einen weiteren Abschnitt des Vorlaufzweigs 35.2 und des Rücklaufzweigs 35.3 an einen in einem Elektronikgehäuse 33 aufgenommenen Wasser/Wasser-Wärmetauscher 36 angeschlossen. In dem Elektronikgehäuse 33 ist eine Überwachungs- und Steuerungseinrichtung 39 für Funktionen des Schaltschrankes oder Racks 32 aufgenommen, die u.a. auch an den Vorlaufzweig 35.2 und den Rücklaufzweig 35.3 angeschlossen ist, um die dort vorhandenen Temperaturen der Flüssigkeit bzw. des Wassers zu erfassen.

Über weitere Leitungen ist der Wasser/Wasser-Wärmetauscher 6 an eine Rückkühlanlage 7 angeschlossen, die eine zuverlässige Kühlung der Kühlflüssigkeit sicherstellt und die Möglichkeit bietet, die entstandene Wärme auch z.B. außerhalb des Raumes abzugeben, indem sich das Rack 32 oder der Schaltschrank mit den zu kühlenden Elektronikbaugruppen befindet, um eine zu hohe Raumtemperatur zu vermeiden.

Zudem ist der obere Bereich des zentralen Flüssigkeitsleitungssystems 35 mit dem Kühlmittelführungselement 20 über weitere Leitungen an einen auf dem Rack 32 oder Schaltschrank angeordneten Luft/Wasser-Wärmetauscher 38 angeschlossen, mit dem eine weitere Kühlung der Flüssigkeit erreicht wird und zudem auch, bei entsprechender Ausgestaltung, die Allgemeintemperatur im Bereich der Baugruppen bzw. im Innenraum des Schaltschrankes herabgesetzt werden kann.

Ferner sind in dem Rack 32 beispielhaft auch eine Monitor-Tastatur-Einheit 40 und eine Server-Schaltsteuerung (Server-Switch-Control) 41 angeordnet, die aber wegen der geringeren Wärmeproduktion nicht an das zentrale Flüssigkeitsleitungssystem 5 angeschlossen sein müssen.

Stellt die Überwachungs- und Steuerungseinrichtung 39 z.B. mittels Temperaturfühler oder Flüssigkeitsströmungswächter in oder an dem Flüssigkeitsleitungssystem fest, dass z.B. die Absoluttemperatur im Rücklaufzweig 35.3 oder eine Temperaturdifferenz zwischen dem Vorlaufzweig 35.2 und dem Rücklaufzweig 35.3 eine vorgegebene oder vorgebbare Schwelle überschreitet, gibt sie ein Fehlersignal oder eine Fehlermeldung ab, mit dem z.B. eine Warnlampe oder ein Warnton eingeschaltet oder eine Anzeige zur Information eines Benutzers gesteuert werden können, wobei auch eine Weiterleitung über einen Netzwerkanschluss an eine entfernte Überwachungsstelle möglich ist. Eine vorteilhafte Maßnahme besteht auch darin, dass die Überwachungs- und Steuerungseinrichtung 39 so ausgebildet ist, dass sie bei Auftreten eines Fehlersignals eine gemeinsame Stromversorgung der in dem Rack 32 bzw. Schaltschrank befindlichen Elektronikbaugruppen 31 abschaltet, so dass sichergestellt ist, dass kein Temperaturschaden dieser in der Regel teuren Einrichtung eintritt.

## Patentansprüche

1. Schaltschrank-Rahmengestell (1), Rack (32) oder IT-Arbeitsplatzsystem mit einer Kühlmittelführungseinrichtung, die mindestens ein Kühlmittelführungselement (20) mit einem umschlossenen längserstreckten hohlen Profilkörper aufweist, dessen Außenwandung mit einer Vielzahl von in Längsrichtung voneinander beabstandeten, freiliegenden oder abgeschlossenen und freigebbaren Zugangsöffnungen (22) zu einer im Inneren befindlichen Kanalanordnung (21.1, 21.2) versehen ist,
**dadurch gekennzeichnet,**
**dass** die Kanalanordnung einen Vorlaufkanal (21.1) und einen Rücklaufkanal (21.2) aufweist, denen jeweils eine Reihe von Zugangsöffnungen (22) zugeordnet ist.

2. Schaltschrank-Rahmengestell, Rack oder IT-Arbeitsplatzsystem nach Anspruch 1,
**dadurch gekennzeichnet,**
**dass** der Vorlaufkanal (21.1) und der Rücklaufkanal (21.2) mittels einer einstückigen Trennwand (21.3) des Profilkörpers voneinander getrennt sind.

3. Schaltschrank-Rahmengestell, Rack oder IT-Arbeitsplatzsystem nach Anspruch 2,
**dadurch gekennzeichnet,**
**dass** die Trennwand (21.3) mit einem Isoliermittel (21.4) geringerer Wärmeleitfähigkeit als das Material des Profilkörpers versehen ist.

4. Schaltschrank-Rahmengestell, Rack oder IT-Arbeitsplatzsystem nach Anspruch 3,
**dadurch gekennzeichnet,**
**dass** das Isoliermittel (21.4) ein sich über die Länge und im Wesentlichen die Breite der Trennwand (21.3) erstreckender Hohlraum oder ein wärmeisolierender Festkörper ist.

5. Schaltschrank-Rahmengestell, Rack oder IT-Arbeitsplatzsystem nach einem der vorhergehenden Ansprüche,
**dadurch gekennzeichnet,**
**dass** die umgebenden Wandflächen des Vorlaufkanals (21.1) und des Rücklaufkanals (21.2) beschichtet sind.

6. Schaltschrank-Rahmengestell, Rack oder IT-Arbeitsplatzsystem nach einem der vorhergehenden Ansprüche,
**dadurch gekennzeichnet,**
**dass** der Profilkörper aus Metall oder Kunststoff extrudiert ist.

7. Schaltschrank-Rahmengestell, Rack, oder IT-Arbeitsplatzsystem nach einem der vorhergehenden Ansprüche,
**dadurch gekennzeichnet,**
**dass** das Kühlmittelführungselement (20) entlang einem Rahmenschenkel (10, 10', 10"), an mindestens einer Montageschiene oder an der Innenseite eines Verkleidungsteils angebracht ist.

8. Schaltschrank-Rahmengestell, Rack oder IT-Arbeitsplatzsystem nach Anspruch 7,
**dadurch gekennzeichnet,**
**dass** der Rahmenschenkel (10) als Rahmenprofil mit einer integrierten, zum Innenraum des Schaltschrankes oder Racks (32) offenen Kammer (11) ausgebildet ist, in die das Kühlmittelführungselement (20) eingesetzt ist.

9. Schaltschrank-Rahmengestell, Rack oder IT-Arbeitsplatzsystem nach Anspruch 8,
**dadurch gekennzeichnet,**
**dass** in der Kammer (11) Haltemittel (11.1) ausgebildet sind, mit denen das Kühlmittelführungselement (20) in dieser fixiert ist.

10. Schaltschrank-Rahmengestell, Rack oder IT-Arbeitsplatzsystem nach Anspruch 8 oder 9,
**dadurch gekennzeichnet,**
**dass** das Kühlmittelführungselement (20) in der Kammer (11) eingerastet, in diesem festgeschraubt, eingeklebt, eingeschweißt oder eingelötet oder eingeklemmt ist.

11. Schaltschrank-Rahmengestell, Rack oder IT-Arbeitsplatzsystem nach einem der Ansprüche 8 bis 10,
**dadurch gekennzeichnet,**
**dass** das Kühlmittelführungselement (20) von einer stirnseitigen Öffnung aus in Längsrichtung des Trageprofils (18) eingeschoben ist oder senkrecht zur Längsrichtung über eine Längsöffnung (11.2) des Trageprofils (18) einsetzbar ist und
**dass** das Kühlmittelführungselement (20) auf seiner über die Längsöffnung (11.2) zugänglichen Längsseite mit den Zugangsöffnungen (22) versehen ist.

12. Schaltschrank-Rahmengestell, Rack oder IT-Arbeitsplatzsystem nach einem der vorhergehenden Ansprüche,
**dadurch gekennzeichnet,**
**dass** entlang dem Kühlmittelführungselement (20) in Längsrichtung verlaufende Kühlrippen (23) angeordnet sind.

13. Schaltschrank-Rahmengestell, Rack oder IT-Arbeitsplatzsystem nach einem der vorhergehenden Ansprüche,
**dadurch gekennzeichnet,**
**dass** die äußere Querschnittskontur des Kühlmittelführungselementes (20) an die innere Querschnittskontur der Kammer (11) angepasst ist.

14. Schaltschrank-Rahmengestell, Rack oder IT-Arbeitsplatzsystem nach einem der vorhergehenden Ansprüche,
**dadurch gekennzeichnet,**
**dass** das Rahmenprofil (10) mindestens zwei Kammern (11, 17) aufweist, von denen eine die Aufnahme-Kammer (11) für das Kühlmittelführungselement bildet und die weitere(n) (17) zu Montagezwecken und/oder Verstärkungszwecken dient (dienen).

15. Schaltschrank-Rahmengestell, Rack oder IT-Arbeitsplatzsystem nach einem der vorhergehenden Ansprüche,
**dadurch gekennzeichnet,**
**dass** im lichten Öffnungsbereich der Kammer (11) zwei gegeneinander gerichtete Haltestege (11.1) angeordnet sind.

16. Schaltschrank-Rahmengestell, Rack oder IT-Arbeitsplatzsystem nach einem der vorhergehenden Ansprüche,
**dadurch gekennzeichnet,**
**dass** das Kühlmittelführungselement (20) über ein oder zwei auf einer oder beiden Stirnseiten in das Rahmenprofil (10) eingesetzte(s) Anschlussteil(e) und/oder über in die Zugangsöffnungen (22) eingesetzte Adapter an eine Kühlmittelzuführung und/oder -abführung angeschlossen oder anschließbar ist.

17. Schaltschrank-Rahmengestell, Rack oder IT-Arbeitsplatzsystem nach einem der vorhergehenden Ansprüche,
**dadurch gekennzeichnet,**
**dass** das Kühlmittelführungselement (20) ein flüssiges Kühlmedium führt und an einen Luft/Flüssigkeits-Wärmetauscher (8) und/oder eine Flüssigkeits/Flüssigkeits-Wärmetauscher (6) angeschlossen ist.

18. Schaltschrank-Rahmengestell, Rack oder IT-Arbeitsplatzsystem nach Anspruch 17,
**dadurch gekennzeichnet,**
**dass** das Kühlmittelführungselement (20) über die Zugangsöffnungen (22) an mit Elektronikbaugruppen (31) thermisch gekoppelte Kühlelemente angeschlossen ist.

## Claims

1. Switchgear cabinet frame (1), rack (32) or IT workstation system having a coolant guiding device which has at least one coolant guiding element (20) comprising an enclosed elongate hollow profiled body, the outer wall of which is provided with a plurality of holes (22) giving access to a channel arrangement (21.1, 21.2) located inside said element, said access holes being arranged spaced apart from each other in the longitudinal direction and being open, or closed and capable of being opened,
**characterised in that**
the channel arrangement has a forward flow channel (21.1) and a backflow channel (21.2), with each of which a series of access holes (22) is associated.

2. Switchgear cabinet frame, rack or IT workstation system according to claim 1,
**characterised in that**
the forward flow channel (21.1) and the backflow channel (21.2) are separated from each other by means of a one-piece partition wall (21.3) of the profiled body.

3. Switchgear cabinet frame, rack or IT workstation system according to claim 2,
**characterised in that**
the partition wall (21.3) is provided with an insulating means (21.4) which has less thermal conductivity than the material of the profiled body.

4. Switchgear cabinet frame, rack or IT workstation system according to claim 3,
**characterised in that**
the insulating means (21.4) is a cavity extending over the length and substantially the breadth of the partition wall (21.3) or is a heat-insulating solid body.

5. Switchgear cabinet frame, rack or IT workstation system according to one of the preceding claims,
**characterised in that**
the surrounding wall surfaces of the forward flow channel (21.1) and of the backflow channel (21.2) are coated.

6. Switchgear cabinet frame, rack or IT workstation system according to one of the preceding claims,
**characterised in that**
the profiled body is extruded from metal or plastics material.

7. Switchgear cabinet frame, rack or IT workstation system according to one of the preceding claims,
**characterised in that**
the coolant guiding element (20) is attached along a frame member (10, 10', 10"), to at least one mounting rail or on the inside of part of the panelling.

8. Switchgear cabinet frame, rack or IT workstation system according to claim 7,
**characterised in that**
the frame member (10) is designed as a frame profile having an integrated chamber (11) which is open towards the interior of the switchgear cabinet or rack (32).

9. Switchgear cabinet frame, rack or IT workstation system according to claim 8,
**characterised in that**
in the chamber (11) are formed holding means (11.1) for fixing the coolant guiding element (20) in said chamber.

10. Switchgear cabinet frame, rack or IT workstation system according to claim 8 or 9,
**characterised in that**
the coolant guiding element (20) is locked, screwed, glued, welded or soldered or clamped into the chamber (11).

11. Switchgear cabinet frame, rack or IT workstation system according to one of claims 8 to 10,
**characterised in that**
the coolant guiding element (20) is inserted from an end-face opening in the longitudinal direction of the supporting profile (18) or may be inserted perpendicular to the longitudinal direction via a longitudinal opening (11.2) of the supporting profile (18), and
**in that** the coolant guiding element (20) is provided with the access holes (22) on its longitudinal side which is accessible via the longitudinal opening (11.2).

12. Switchgear cabinet frame, rack or IT workstation system according to one of the preceding claims,
**characterised in that**
cooling ribs (23) extending in the longitudinal direction are arranged along the coolant guiding element (20).

13. Switchgear cabinet frame, rack or IT workstation system according to one of the preceding claims,
**characterised in that**
the outside cross-sectional contour of the coolant guiding element (20) is matched to the inside cross-sectional contour of the chamber (11).

14. Switchgear cabinet frame, rack or IT workstation system according to one of the preceding claims,
**characterised in that**
the frame profile (10) has at least two chambers (11, 17), of which one forms the receiving chamber (11) for the coolant guiding element and the other(s) is (are) used for mounting and/or reinforcing purposes.

15. Switchgear cabinet frame, rack or IT workstation system according to one of the preceding claims,
**characterised in that**
two holding webs (11.1), which are directed against each other, are arranged in the interior of the chamber (11).

16. Switchgear cabinet frame, rack or IT workstation system according to one of the preceding claims,
**characterised in that**
the coolant guiding element (20) is or may be connected to a coolant supply and/or coolant discharge via one or two connector(s) inserted into the frame profile (10) on one or both end faces, and/or via adapters inserted into the access holes (22).

17. Switchgear cabinet frame, rack or IT workstation system according to one of the preceding claims,
**characterised in that**
the coolant guiding element (20) guides a liquid coolant and is connected to an air/liquid heat exchanger (8) and/or a liquid/liquid heat exchanger (6).

18. Switchgear cabinet frame, rack or IT workstation system according to claim 17,
**characterised in that**
the coolant guiding element (20) is connected via the access holes (22) to cooling elements which are thermally coupled to electronic subassemblies (31).

## Revendications

1. Baie d'armoire de distribution (1), rack (32) ou système de poste de travail informatique avec un dispositif de conduite de fluide de refroidissement qui présente un élément de conduite de fluide de refroidissement (20) comportant un corps profilé creux enclos s'étendant en longueur dont la paroi extérieure est pourvue d'une pluralité d'ouvertures d'accès (22) espacées en direction longitudinale, ouvertes ou fermées et pouvant être ouvertes vers un agencement de canaux (21.1, 21.2) se trouvant à l'intérieur,
**caractérisé**(e) par le fait
que l'agencement de canaux présente un canal de départ (21.1) et un canal de retour (21.2) à chacun desquels est associée une série d'ouvertures d'accès (22).

2. Baie d'armoire de distribution, rack ou système de poste de travail informatique selon la revendication 1,
**caractérisé**(e) par le fait
que le canal de départ (21.1) et le canal de retour (21.2) sont séparés l'un de l'autre au moyen d'une paroi de séparation (21.3) en une pièce du corps profilé.

3. Baie d'armoire de distribution, rack ou système de poste de travail informatique selon la revendication 2,
**caractérisé**(e) par le fait
que la paroi de séparation (21.3) est pourvue d'un moyen isolant (21.4) de plus faible conductibilité thermique que le matériau du corps profilé.

4. Baie d'armoire de distribution, rack ou système de poste de travail informatique selon la revendication 3,
**caractérisé**(e) par le fait
que le moyen isolant (21.4) est un espace creux s'étendant sur la longueur et essentiellement la largeur de la paroi de séparation (21.3) ou un solide isolant.

5. Baie d'armoire de distribution, rack ou système de poste de travail informatique selon l'une des revendications précédentes,
**caractérisé**(e) par le fait
que les surfaces de paroi périphériques du canal de départ (21.1) et du canal de retour (21.2) sont revêtues.

6. Baie d'armoire de distribution, rack ou système de poste de travail informatique selon l'une des revendications précédentes,
**caractérisé**(e) par le fait
que le corps profilé est réalisé par extrusion de métal ou de matière plastique.

7. Baie d'armoire de distribution, rack ou système de poste de travail informatique selon l'une des revendications précédentes,
**caractérisé**(e) par le fait
que l'élément de conduite de fluide de refroidissement (20) est monté le long d'un montant de cadre (10, 10', 10") sur au moins un rail de montage ou sur le côté intérieur d'une pièce d'habillage.

8. Baie d'armoire de distribution, rack ou système de poste de travail informatique selon la revendication 7,
**caractérisé**(e) par le fait
que le montant de cadre (10) est réalisé sous la forme d'un profilé de cadre avec une chambre (11) intégrée, ouverte vers l'intérieur de l'armoire de distribution ou du rack (32), dans laquelle l'élément de conduite de fluide de refroidissement (20) est inséré.

9. Baie d'armoire de distribution, rack ou système de poste de travail informatique selon la revendication 8,
**caractérisé**(e) par le fait
que l'on forme dans la chambre (11) des moyens de retenue (11.1) avec lesquels l'élément de conduite de fluide de refroidissement (20) est fixé dans celle-ci.

10. Baie d'armoire de distribution, rack ou système de poste de travail informatique selon la revendication 8 ou 9,
**caractérisé**(e) par le fait
que l'élément de conduite de fluide de refroidissement (20) est encliqueté dans la chambre (11), vissé, collé, soudé ou brasé ou coincé dans celle-ci.

11. Baie d'armoire de distribution, rack ou système de poste de travail informatique selon l'une des revendications 8 à 10,
**caractérisé**(e) par le fait
que l'élément de conduite de fluide de refroidissement (20) est introduit depuis une ouverture frontale en direction longitudinale du profilé porteur (18) ou peut être inséré perpendiculairement à la direction longitudinale par une ouverture longitudinale (11.2) du profilé porteur (18) et
que l'élément de conduite de fluide de refroidissement (20) est pourvu des ouvertures d'accès (22) sur son côté long accessible par l'ouverture longitudinale (11.2).

12. Baie d'armoire de distribution, rack ou système de poste de travail informatique selon l'une des revendications précédentes,
**caractérisé**(e) par le fait
que des ailettes de refroidissement (23) s'étendant en direction longitudinale sont disposées le long de l'élément de conduite de fluide de refroidissement (20).

13. Baie d'armoire de distribution, rack ou système de poste de travail informatique selon l'une des revendications précédentes,
**caractérisé**(e) par le fait
que le contour extérieur de l'élément de conduite de fluide de refroidissement (20) est adapté au contour intérieur de la chambre (11).

14. Baie d'armoire de distribution, rack ou système de poste de travail informatique selon l'une des revendications précédentes,
**caractérisé**(e) par le fait
que le profilé de cadre (10) présente au moins deux chambres (11, 17) dont l'une forme la chambre de réception (11) pour l'élément de conduite de fluide de refroidissement et l'autre ou les autres (17) sert/servent à des fins de montage et/ou de renforcement.

15. Baie d'armoire de distribution, rack ou système de poste de travail informatique selon l'une des revendications précédentes,
**caractérisé**(e) par le fait
que deux nervures de retenue (11.1) dirigées l'une vers l'autre sont disposées dans la zone d'ouverture libre de la chambre (11).

16. Baie d'armoire de distribution, rack ou système de poste de travail informatique selon l'une des revendications précédentes,
**caractérisé**(e) par le fait
que l'élément de conduite de fluide de refroidissement (20) est raccordé ou peut être raccordé à une amenée et/ou une évacuation de fluide de refroidissement par une ou deux pièce(s) de raccordement insérée(s) sur une ou deux faces frontales dans le profilé de cadre (10) et/ou par des adaptateurs insérés dans les ouvertures d'accès (22).

17. Baie d'armoire de distribution, rack ou système de poste de travail informatique selon l'une des revendications précédentes,
**caractérisé**(e) par le fait
que l'élément de conduite de fluide de refroidissement (20) conduit un fluide de refroidissement liquide et est raccordé à un échangeur de chaleur air/liquide (8) ou à un échangeur de chaleur liquide/liquide (6).

18. Baie d'armoire de distribution, rack ou système de poste de travail informatique selon la revendication 17,
**caractérisé**(e) par le fait
que l'élément de conduite de fluide de refroidissement (20) est raccordé par les ouvertures d'accès (22) à des éléments de refroidissement thermiquement couplés à des sous-ensembles électroniques (31).
